# EUROPÄISCHE PATENTSCHRIFT

(11) **EP 1 208 584 B1**
(45) Veröffentlichungstag und Bekanntmachung des Hinweises auf die Patenterteilung: **07.05.2003**
(21) Anmeldenummer: 00951185.8
(22) Anmeldetag: 24.08.2000
(51) Int. Cl.: H01L 21/00

(54) **HANDHABUNGSVORRICHTUNG ZUR BEREITSTELLUNG EINES WAFER-STAPELS**
HANDLING DEVICE FOR PREPARING A WAFER STACK
DISPOSITIF DE MANIPULATION POUR METTRE A DISPOSITION UNE PILE DE TRANCHES DE SILICIUM

(30) Priorität: 27.08.1999 CH 156999
(43) Veröffentlichungstag der Anmeldung: 29.05.2002
(73) Patentinhaber: Brooks Automation AG, 8274 Tägerwilen (CH)
(72) Erfinder: FEDERICI, Rudy, CH-8572 Berg (CH); BLATTNER, Jakob, CH-8272 Ermatingen (CH)
(74) Vertreter: EGLI-EUROPEAN PATENT ATTORNEYS
(86) Internationale Anmeldenummer: CH0000451
(87) Internationale Veröffentlichungsnummer: WO01017000

(56) Entgegenhaltungen:
- EP-A- 0 496 006
- US-A- 4 695 217
- US-A- 5 261 776
- US-A- 5 501 568

## Beschreibung

Die Erfindung betrifft eine Greifvorrichtung zur Handhabung mehrerer Wafer oder anderer scheibenförmiger Substrate. Weiterhin betrifft die Erfindung eine Handhabungsvorrichtung für Wafer (Halbleiterscheiben) oder anderer scheibenförmiger Substrate, welche eine Lagereinrichtung aufweist, in der mehrere Wafer mit ihren Oberflächen im Wesentlichen parallel zueinander ausgerichtet, hintereinander und ausserhalb eines Transportbehälters anordenbar sind, sowie mit einer Greifvorrichtung versehen ist, mit welcher einzelne Wafer aus der Lagereinrichtung entnehmbar und/oder in sie einsetzbar sind.

Grundlage für die Herstellung elektronischer Bauteile sind beispielsweise in bestimmter Weise vorbearbeitete Halbleiterscheiben, sogenannte Wafer, oder LCD-Glassubstrate. Für deren Oberflächenbearbeitung müssen sie verschiedene Prozessstufen durchlaufen. Dabei werden Roh-Wafer (unprozessierte Wafer) hergestellt und in der Regel zwischen dem Durchlaufen von einzelnen Prozessstufen in Transport- und Aufbewahrungsbehältern zwischengelagert. Für den eigentlichen Bearbeitungsprozess müssen diese un- bzw. erst teilweise prozessierten Wafer dem Behälter entnommen werden, einer Vorrichtung zur Durchführung des Bearbeitungsprozesses zugeführt und anschliessend wieder in einen Behälter abgelegt werden. Die Anzahl der in einem Behälter vorgesehenen Wafer wird auch als "Batch" (Stapel) bezeichnet. Die Batch-Grösse ist genormt und beträgt üblicherweise 25 (oder 13) Wafer.

Ein grundlegendes Problem bei der gesamten Verarbeitung und Zwischenlagerung besteht darin, dass die Wafer von Verunreinigungen und Schmutz ferngehalten werden müssen. Bereits kleinste Verunreinigungen durch Staub oder sonstige Partikel erzeugen eine Schädigung des entsprechenden Bereiches der Wafer-Oberfläche. Dies kann zu erheblichen Ausschussraten der aus diesen Wafern hergestellten Endprodukte führen. Deshalb erfolgt die Verarbeitung üblicherweise in sogenannter Reinraumtechnik, d.h. die Verarbeitungszonen müssen eine bestimmte festgelegte Reinheit in Bezug auf diese Schmutzpartikel aufweisen. Dasselbe gilt selbstverständlich auch für die Zwischenlagerung, d.h. für die Aufbewahrungsbehälter.

Es hat sich gezeigt, dass qualitative Unterschiede bei Wafern eines Batches entstehen können, wenn diese stets in der gleichen Reihenfolge die einzelnen Prozessstufen durchlaufen. Es kann deshalb von Vorteil sein, wenn die Reihenfolge der Wafer innerhalb eines Batches verändert wird. Um Wafer an unterschiedlichen Stellen eines Batches anzuordnen, sind bereits Vorrichtungen bekannt geworden, bei denen eine als Einzelgreifer ausgebildete Greifvorrichtung jeweils einen Wafer aus einem in einer Kassette angeordneten Batch entnimmt und in einer anderen Kassette - oder sonstigen Halteeinrichtung - an einem anderen Kassettenplatz ablegt. Das Batch ist für den nächsten Prozess zusammengestellt, sobald der Einzelgreifer sämtliche Wafer jeweils einzeln entnommen und in der anderen Kassette an einer vorbestimmten Stelle abgelegt hat. Diese Vorrichtung hat jedoch den Nachteil, dass die Zusammenstellung des Batches relativ viel Zeit in Anspruch nimmt. Ausserdem ist es mit dieser Vorrichtung kaum möglich, aus unterschiedlichen Batches einen neuen Batch zusammenzustellen.

Beispielsweise aus der EP 0 496 006 A1 sowie der US 4,695,217 sind auch Handhabungsvorrichtungen für Wafer vorbekannt, die jeweils zwei parallel zueinander angeordnete Halterollen aufweisen, die um ihre jeweilige Längsachse rotierbar sind. Die Halterollen sind mit entlang des Umfangs jeder Halterolle verlaufenden Schlitzen versehen. Mittels der beiden Halterollen kann somit jeder Wafer eines Waferstapels dadurch gehalten werden, dass er in jeweils einem Schlitz der beiden Halterollen angeordnet wird. Ferner weisen die Halterollen Bereiche mit einer geringen radialen Erstreckung auf. Werden diese Bereiche jeder Halterolle durch Rotation der Halterollen in eine Position gebracht, in der sich die Bereiche gegenüberliegen, so kann ein Waferstapel zwischen den Halterollen hindurchgeführt werden, beispielsweise um ihn einem bereits auf den Halterollen angeordneten anderen Waferstapel hinzuzufügen. Dieser Typ von vorbekannten Handhabungsvorrichtungen weist jedoch den Nachteil auf, dass er nur die Handhabung von bereits existierenden Waferstapeln zulässt.

Der Erfindung liegt deshalb die Aufgabe zugrunde, eine Greifvorrichtung zu schaffen, die das Zusammenstellen eines Stapel von zu bearbeitenden Wafern in beliebiger aber vorbestimmter Reihenfolge möglichst effizient unterstützt. Weiterhin soll eine Handhabungsvorrichtung mit entsprechenden Eigenschaften geschaffen werden.

Die Aufgabe wird durch eine Greifvorrichtung nach Anspruch 1 gelöst. Die Lösung weist die Merkmale auf, dass die Greifvorrichtung mehrere Greifer aufweist, welche gemeinsam verfahrbar, jedoch unabhängig voneinander betätigbar sind, wobei durch die Betätigung eines Greifers jeweils zumindest ein Wafer erfassbar und/oder in die Lagereinrichtung einsetzbar ist. Hierdurch ist es möglich, gegenüber vorbekannten gattungsgemässen Vorrichtungen die für die Zusammenstellung eines Wafer-Batches erforderlichen Verfahrwege erheblich zu verkürzen.

Die Handhabungsvorrichtung nach Anspruch 2 kann es ermöglichen, mit mehreren einzeln betätigbaren Greifern zuerst mehrere Wafer zu erfassen und aus der Lagereinrichtung zu entnehmen und diese Wafer erst anschliessend gemeinsam, vorzugsweise in eine andere Lageroder Halteeinrichtung einzusetzen. Der Verfahrweg zwischen der Lagereinrichtung und der Halteeinrichtung kann somit um so stärker verkürzt werden, je mehr Wafer die Greifvorrichtung mit einzeln betätigbaren Greifern aufnehmen kann, bevor sie diese an anderer Stelle an die Halteeinrichtung übergibt. Die Wafer sollten deshalb auch bereits bei der Entnahme aus der Lagereinrichtung, in der Greifvorrichtung in der Reihenfolge angeordnet sein, welche sie auch in der Halteeinrichtung bzw. für den nächsten Prozess aufweisen sollen. Dies lässt sich besonders einfach erreichen, wenn über eine Steuerung einer Handhabungsvorrichtung frei wählbar ist, welcher Wafer mit welchem Greifer erfasst wird.

In einer bevorzugten Ausführungsform kann die Anzahl der in einer Greifvorrichtung vorhandenen Greifern, der Anzahl an Wafern eines Waferbatches entsprechen. Die Greifer können deshalb so ausgeführt sein, dass auch eine Verdichtung eines Waferstapels durchgeführt werden kann. Unter Verdichtung ist zu verstehen, dass zwischen jeweils zwei Wafern eines ersten Stapels oder Batches ein oder mehrere Wafer von ein oder mehreren anderen Batches eingeschoben werden sollen. Unter Verdichtung kann aber auch verstanden werden, dass der Abstand aufeinander folgender Wafer im zu erstellenden Waferstapel geringer ist als im Ausgangsstapel. Hierdurch kann bei gleichem Platzbedarf eine grössere Anzahl an Wafern bearbeitet werden. Eine solche Verdichtung ist oftmals erwünscht, um die Wirtschaftlichkeit von Prozessanlagen zu erhöhen, indem mehr als nur ein Waferbatch gleichzeitig bearbeitet wird.

Es ist zwar bevorzugt, dass ein Greifer einer Handhabungsvorrichtung jeweils nur einen Wafer handhaben kann. In Abhängigkeit von den an die Handhabungsvorrichtung gestellten Anforderungen könnte aber auch vorgesehen sein, dass unter den mehreren unabhängig voneinander betätigbaren Greifern zumindest ein Greifer vorgesehen ist, der mehrere Wafer aufnehmen kann.

Eine konstruktiv besonders unaufwendige Ausführungsform einer Greifvorrichtung kann vorsehen, dass Greifer in zwei Endlagen schwenkbar sind, wobei in einer ersten Endlage, nämlich einer Leerposition des Greifers, sich kein Wafer im Greifer befindet und in einer zweiten Endlage, einer Transportposition für Wafer, ein Wafer im Greifer angeordnet ist. Um einen Wafer aus der Lagereinrichtung zu entnehmen, ist der entsprechende Greifer von seiner Leerposition in seine Greifposition zu überführen. Bei dieser Bewegung erfasst der Greifer den Wafer und führt ihn aus der Lagereinrichtung heraus. Umgekehrt übergibt der Greifer bei der Bewegung von der Transportposition in die Leerposition den jeweiligen Wafer an die Lagereinrichtung. Beim Verfahren der Greifvorrichtung entlang der Lagereinrichtung befindet sich jeder der Greifer in einer der beiden Endlagen.

Eine weitere zweckmässige Ausgestaltung der Greifvorrichtung kann vorsehen, dass Greifer der Greifvorrichtung, unabhängig von anderen Greifern einzeln und im wesentlichen parallel zu den Oberflächen der Wafer sowie quer zur Verfahrrichtung der Greifvorrichtung zumindest näherungsweise geradlinig, d.h. translatorisch, bewegbar sind. Auch bei dieser Ausführungsform kann jeder Greifer der Greifvorrichtung in eine Leerund in eine Greifposition überführbar sein und hierbei die gleichen Funktionen ausüben, wie die mit schwenkbaren Greifern versehene Ausführungsform.

Die Aufgabe wird auch durch eine Speichervorrichtung für eine Zwischenlagerung von Wafern gelöst, die ein Gehäuse aufweist, das einen Innenraum ausbildet in dem mehrere Speicherplätze für Transportbehälter von Wafern vorhanden sind, die mit einem Manipulator versehen ist, welcher die Transportbehälter handhabt, wobei zumindest ein Teil des Innenraumes als Reinraumbereich ausgebildet ist, in dem Wafer ausserhalb von Transportbehältern handhabbar und in einer Lagereinrichtung zwischenlagerbar sind und die im Innenraum zumindest eine Greifvorrichtung aufweist.

Durch die Erfindung ist es somit möglich, die Funktionalität von Speichervorrichtungen erheblich zu steigern. Es ist nun möglich, in die Speichervorrichtung Transportbehälter mit einem Wafer-Batch einzulagern und den gleichen Transportbehälter mit einem darin angeordneten, völlig anders zusammengestellten, Wafer-Batch zu entnehmen, der zur weiteren Bearbeitung sofort einer Prozessanlage zugeführt werden kann. Sollte bisher die Reihenfolge der Wafer in einem Wafer-Batch verändert oder einzelne Wafer des Batches ausgetauscht werden, so musste dies in einer gesonderten Anlage durchgeführt werden. Dies benötigte zusätzliche Stellfläche. Da in den Halbleiterfabriken Stellfläche aufgrund den in jeder Fabrik zu schaffenden Reinraumbedingungen besonders teuer ist, kann durch die Integration der Greifvorrichtung die insgesamt erforderliche Stellfläche vorteilhaft verringert werden.

Ein weiterer Aspekt der Erfindung betrifft ein Verfahren zur Zusammenstellung eines Wafer-Batches, wie es in den Ansprüchen 12 oder 13 wiedergegeben ist. Bei vorbekannten Verfahren ist vorgesehen, dass in einem Zyklus zunächst jeweils ein Wafer mit einem Einzelgreifer aus einem in einer Lagereinrichtung angeordneten Waferstapel entnommen und in einer Halteeinrichtung angeordnet wird. Dieser Zyklus wird mit anderen Wafern, unter Verwendung des stets gleichen Greifers so lange wiederholt, bis das Wafer-Batch zusammengestellt ist. In Abkehr hiervon kann bei einem erfindungsgemässen Verfahren vorgesehen sein, dass zunächst mit einer Greifvorrichtung nacheinander mehrere Wafer, vorzugsweise ein vollständiges Wafer-Batch, aus dem Ausgangs-Waferstapel entommen wird. Erst nachdem von der Greifvorrichtung mehrere Wafer nacheinander entnommenen worden sind, werden die Wafer von der Greifvorrichtung, vorzugsweise gleichzeitig, an die Lagereinrichtung oder eine hiervon abweichende Halteeinrichtung übergeben.

Zur Durchführung des erfindungsgemässen Verfahrens kann in der Lagereinrichtung ein Ausgangs-Waferstapel angeordnet sein, der eine Anzahl an Wafern aufweist, die vorzugsweise ein Vielfaches des zu erstellenden Wafer-Batches entspricht. Die Durchführung des Verfahrens ist aber selbstverständlich bereits möglich, wenn die Anzahl der Wafer des Ausgangsstapels zumindest der Anzahl der Wafer des zu erstellenden Waferstapels entspricht.

Mit dem Verfahren kann die zur Zusammenstellung eines Waferbatches erforderliche Zeit erheblich reduziert werden.

Weitere bevorzugte Ausgestaltungen der Erfindung ergeben sich aus den abhängigen Ansprüchen.

Die Erfindung wird anhand den in den Figuren schematisch dargestellten Ausführungsbeispielen näher erläutert; es zeigen:
- Fig. 1: eine perspektivische Darstellung einer erfindungsgemässen Speichervorrichtung;
- Fig. 2: eine Grundrissdarstellung der in Fig. 1 gezeigten Speichervorrichtung;
- Fig. 2a: eine Seitenansicht der erfindungsgemässen Speichervorrichtung aus Fig. 1;
- Fig. 3: eine stark schematisierte perspektivische Darstellung einer vor einer teilweise darge stellten Lagereinrichtung angeordneten erfin dungsgemässen Greifvorrichtung;
- Fig. 3a: eine stark schematisiert perspektivische Dar stellung einer vor einer Transferstation an geordneten erfindungsgemässen Greifvorrich tung;
- Fig. 4: ein einzelner Greifer der Vorrichtung aus Fig. 3 in einer Greifposition;
- Fig. 5: zwei Endlagen des Greifers aus Fig. 4;
- Fig. 6: eine Vorderansicht eines weiteren Ausführungsbeispiels einer Greifvorrichtung, bei der ein Greifer in zwei verschiedenene Endlagen gezeigt ist.

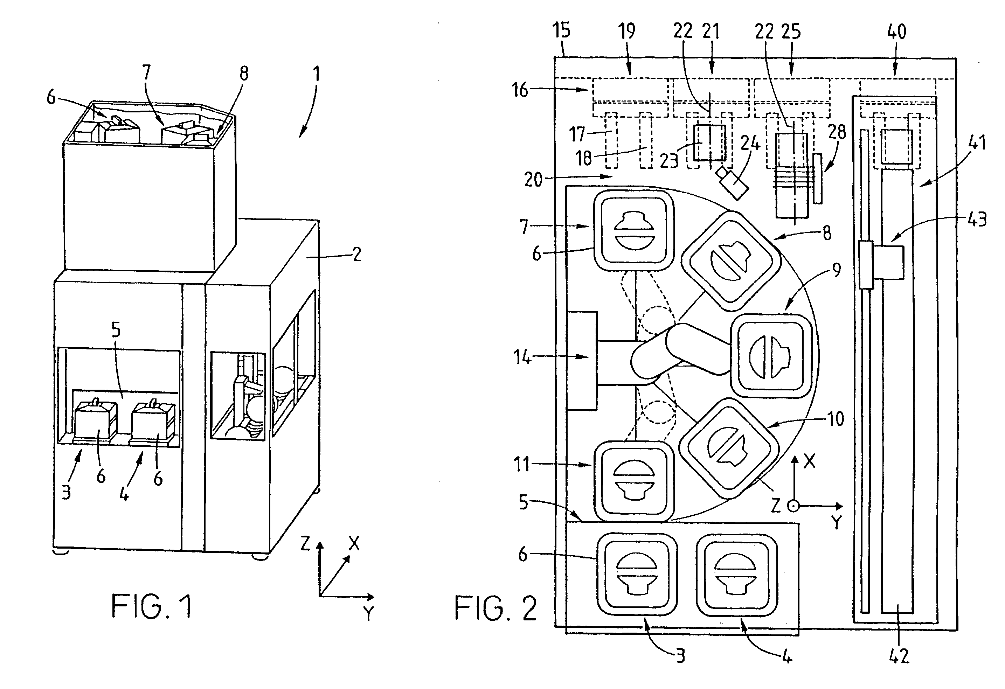

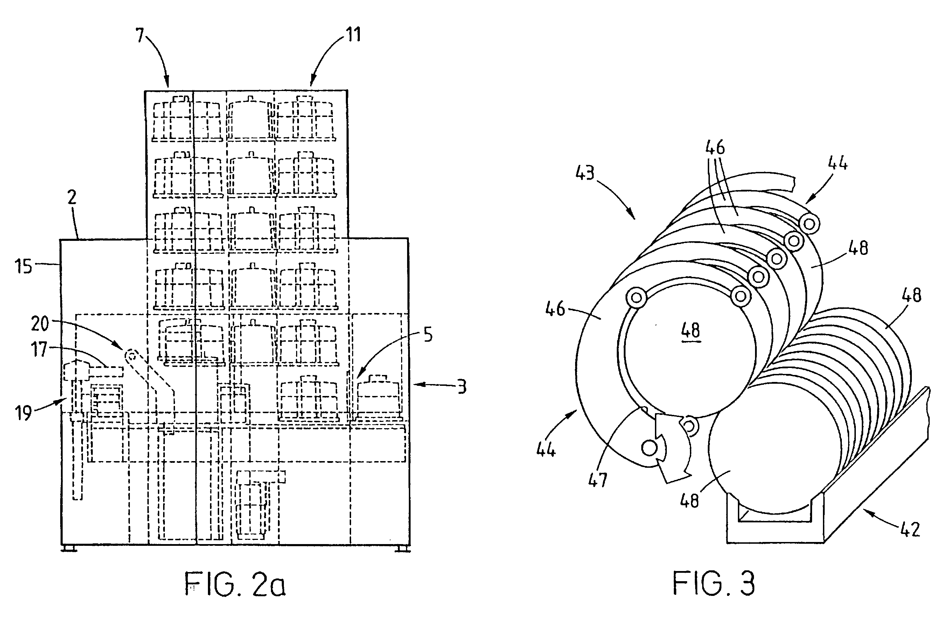

Die Fig. 1 und 2 zeigen eine Speichervorrichtung 1 (sogenannter "Stocker") für Wafer. Durch ein Gehäuse 2 der Speichervorrichtung 1 wird ein Innenraum ausgebildet, in dem Reinraumbedingungen herrschen. Die Speichervorrichtung 1 weist zwei Schleusenplätze 3, 4 auf, auf denen Transportbehälter für Wafer zur Ein- oder Ausgabe von der Speichervorrichtung positioniert werden können. Transportbehälter können geschlossene Boxen oder offene Kassetten sein. Am Schleusenplatz 3 ist eine nicht dargestellte Transporteinrichtung vorhanden, mit der ein Transportbehälter 6 durch Öffnen einer Schleusentür 5 ins Innere der Speichervorrichtung 1 einführbar bzw. aus der Speichervorrichtung 1 herausführbar ist. Unmittelbar gegenüber der Schleusenplätze 3, 4 befinden sich fünf in etwa zueinander halbkreisförmig angeordnete Speicherzeilen 7, 8, 9, 10, 11. Jede der vier ersten Speicherzeilen weist eine bestimmte Anzahl übereinander angeordnete Speicherplätze für Transportbehälter 6 auf. Die fünfte Speicherzeile 7 weist einen Speicherplatz weniger als die anderen Speicherzeilen auf, da im Bereich unter ihr die in einem Transportbehälter 6 angeordneten Wafer durch ein Übergabemodul vom Stocker an eine Anlage 16 zur Handhabung von Wafern übergeben werden. Ein in vertikaler Richtung (Z-Achse) verfahrbarer, als Knickarmroboter 14 ausgebildeter Manipulator, handhabt die Transportbehalter 6, indem er die Transportbehälter von der Schleusentür 5 aus in einen Speicherplatz absetzt bzw. von letzterem zur Schleusentür 5 überführt.

An einer der Schleusentür 5 gegenüberliegenden Wandfläche 15 der Speichervorrichtung 1 ist die Anlage 16 zur Handhabung eines Waferbatches vorgesehen. Hierbei handelt es sich im Wesentlichen um zwei parallel zueinander ausgerichtete Rollen 17, 18, an deren Umfang nicht näher dargestellte Aufnahmen zum Halten der Wafer in einer vertikalen Position vorgesehen sind. Die Wafer werden mittels einem vertikal verfahrbaren Batch-Greifer vom Transportbehälter an die horizontal verfahrbaren Rollen 17, 18 übergeben und dort in Aufnahmen eingesetzt.

Die Rollen sind gemeinsam in Y-Richtung verfahrbar, um die Wafer in einer von vier punktiert dargestellten Stationen anzuordnen. Bei jeder Station befindet sich ein nicht näher gezeigter vertikal (Z-Achse) verfahrbarer Halterechen. Jeder der Halterechen kann durch vertikales Verfahren zwischen den Rollen 17, 18 von diesen die Wafer übernehmen bzw. an sie übergeben. Der Aufbau und die Funktionsweise einer solchen Anlage ist in der europäischen Patentanmeldung Nr. 97 115 686.4 vom 10.09.1997 der Anmelderin beschrieben, deren Inhalt durch Bezugnahme vollständig aufgenommen wird.

Die erste Station 19 dient zur Übergabe der Wafer eines Transportbehälters an die Rollen. Hierzu ist im mit dem Bezugszeichen 20 (Fig. 2, 2a) gekennzeichneten Bereich das Übergabemodul eine Anlage vorgesehen mit der die Wafer mittels eines Batch-Greifers aus jeweils der untersten Transportbox der Speicherzeile 7 entnommen und an die Rollen 17, 18 übergeben werden können. Eine Anlage, mit der dies ausgeführt werden kann, ist in der europäischen Patentanmeldung Nr. 97 107 352.3 vom 03.05.1997 der Anmelderin gezeigt. Auch der Inhalt dieser Anmeldung wird hiermit durch Bezugnahme vollständig aufgenommen.

Die zweite Station 21 dient zur Ausrichtung der Wafer in Bezug auf ihre rotative Orientierung um eine Längsachse 22 eines Batches 23, sowie zur Detektierung von Fehlpositionierungen der Wafer im Halterechen. Die Rotationsposition von jedem der Wafer wird durch Detektierung einer an jedem Wafer vorhandenen Kerbe festgestellt. Als weitere Funktion ist eine Kamera 24 eingebaut, welche die Anzahl und die Position der Wafer überwacht.

Die dritte Station 25 ist mit einer Greifvorrichtung 28 versehen, die 25 einzeln und voneinander unabhängig betätigbare Einzelgreifer aufweist. Sämtliche Greifer sind an einem gemeinsamen Träger beweglich befestigt. Die als Halterechen dieser Station ausgebildete Lagereinrichtung ist gegenüber dem ortsfesten Träger zusätzlich auch parallel zum Wafer-Batch und den Rollen in X-Richtung linear verfahrbar. Die Verfahrwege des Halterechens betragen ganzzahlige Vielfache des Abstandes, den die nebeneinander angeordneten Wafer-Aufnahmen im Halterechen aufweisen. Um zu ermöglichen, dass jeder Greifer an sich jeden Wafer aus dem Halterechen entnehmen kann, sollte der Gesamtverfahrweg des Halterechens seiner doppelten Länge entsprechen. Auf den möglichen konstruktiven Aufbau einer solchen Greifvorrichtung wird nachfolgend noch näher eingegangen.

Mit der Greifvorrichtung 28 kann durch jeweils einen Greifer ein bestimmter Wafer aus dem Halterechen entnommen werden. Durch eine Relativbewegung zwischen dem Halterechen und der Greifvorrichtung parallel zur Batch-Achse 22
(Stapelrichtung) wird nachfolgend ein anderer Greifer gegenüber dem nun zu entnehmenden Wafer angeordnet und der Wafer aus dem Halterechen herausgeführt. Dies wird solange durchgeführt, bis sämtliche Wafer des Batches von der Greifvorrichtung erfasst sind. Nachfolgend werden die Wafer von der Greifvorrichtung wieder in den Halterechen eingesetzt. Eine Möglichkeit hierzu besteht darin, dass sämtliche Wafer gleichzeitig von ihrem Greifer in den Halterechen eingesetzt werden. Soll die Position von einem oder mehreren Wafern unverändert bleiben, kann selbstverständlich auch vorgesehen sein, dass diese Wafer im Halterechen verbleiben und nur die zu vertauschenden Wafern entnommen werden.

Alternativ könnte auch vorgesehen sein, dass die einzelnen Greifer - vorzugsweise sämtliche Greifer - gleichzeitig jeweils einen Wafer entnehmen, die Wafer aber nacheinander an nun anderen Stellen des Halterechens wieder einsetzen. Ergibt sich, dass in einer bestimmten Position der Greifvorrichtung gegenüber dem Halterechen mehrere Wafer in ihre neuen Positionen im Halterechen abgesetzt werden können, so können die entsprechenden mindestens zwei Greifer auch gleichzeitig betätigt werden.

Bei diesem Vorgängen kann eine neue Reihenfolge der Wafer erzeugt werden, wobei die neue Reihenfolge davon abhängen kann, welcher Greifer welchen Wafer aus dem Halterechen entnimmt bzw. an welcher Stelle des Halterechens einsetzt. Um die Verfahrwege des Halterechens möglichst kurz zu halten, sollte als jeweils nächster Greifer stets der Greifer zum Einsatz kommen, dessen zu greifender Wafer in der aktuellen Position der Greifvorrichtung den geringsten Abstand zu dem ihm zugeordneten Greifer hat. Welcher Wafer von welchem Greifer erfasst werden soll, kann bereits im Voraus durch eine vordefinierte Reihenfolge festgelegt werden. Es kann aber genauso möglich sein, dass die Reihenfolge durch einen Zufallsgenerator ermittelt wird.

Die vierte Station 40 befindet sich an einer Stirnseite einer Handhabungsvorrichtung 41 für Wafer, in der Wafer ausserhalb von Transportbehältern 6 oder Transportkassetten zwischengelagert werden. Mit der Handhabungsvorrichtung 41 werden zudem Wafer-Batches, aus den in einer Lagereinrichtung 42, mit ihren Oberflächen vertikal und parallel zueinander, angeordneten, mehreren hundert Wafern, beispielsweise 600 Wafern, zusammengestellt.

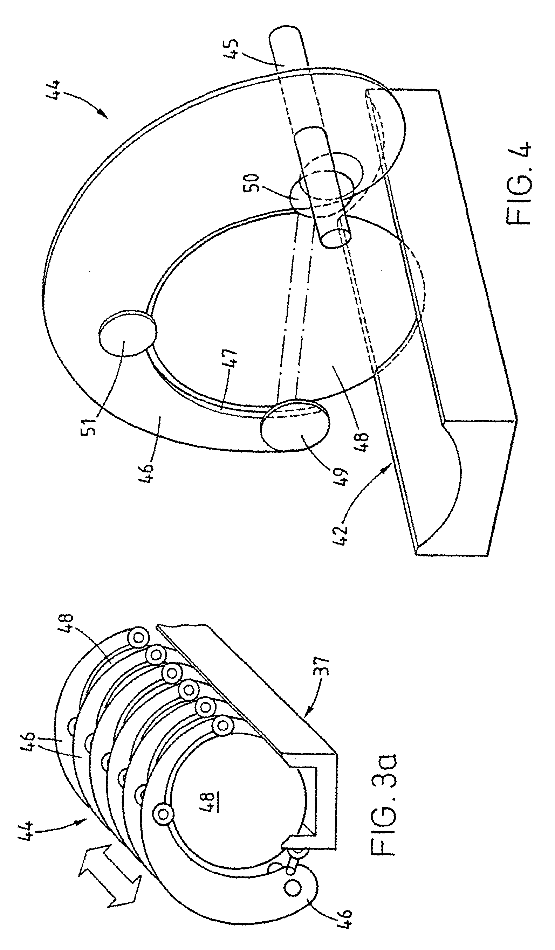

Hierzu ist eine Greifvorrichtung 43 vorgesehen, die im Wesentlichen gleich aufgebaut sein kann, wie die Greifvorrichtung 28 der dritten Station 25. In den Fig. 3, 4 und 5 ist ein erstes Ausführungsbeispiel einer solchen erfindungsgemässen Greifvorrichtung 43 gezeigt. Diese weist insgesamt 25 identische Greifer 44 auf, die an einem Träger 45 schwenkbar angelenkt sind. Jeder Greifer 44 ist mit einem bogenförmigen Schwenkarm 46 versehen. Eine Innenkante 47 des Schwenkarms 46 ist kreisbogenförmig ausgestaltet, erstreckt sich über einen Winkelbereich von ca. 200° und hat einen Radius, der geringfügig grösser ist, als der Radius eines zu greifenden Wafers 48. An einem freien Ende des Schwenkarms 46 sowie im Bereich der Anlenkung des Schwenkarms 46 am Träger 44, ist jeweils ein Halteelement 49, 50 vorgesehen. Die beiden Halteelemente 49, 50 ragen jeweils über die Innenkante 47 hinaus und liegen - bezogen auf den von der Innenkante 47 gebildeten Bogen des Schwenkarms - um mehr als 180° auseinander. Desweiteren ist in etwa in der Mitte zwischen diesen beiden Halteelementen 49, 50 ein passiv betätigbares weiteres Halteelement 51 angebracht, das in einer Endlage ebenfalls über die Innenkante 47 hinausragt. Die drei Halteelemente 49 - 51 liegen in einer gemeinsamen (imaginären) Ebene. Sie weisen an ihrem Umfang jeweils eine nicht gezeigte umlaufende Nut auf, die zur Aufnahme eines Wafers 48 vorgesehen ist.

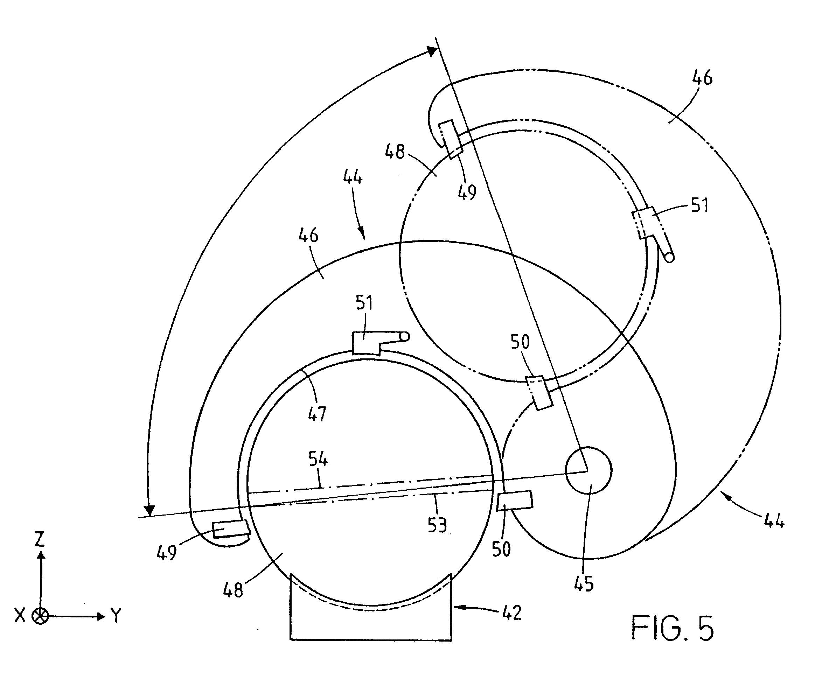

In Fig. 5 sind die beiden Endlagen dargestellt, die der Schwenkarm 46 eines Greifers 44 einnehmen kann. Um bei jedem Greifer eine individuelle Bewegung zu erzielen, können unterschiedliche konstruktive Lösungen vorgesehen sein, deren prinzipieller Aufbau nachfolgend kurz erläutert wird. In einer ersten Ausgestaltung weist die Greifvorrichtung einen zentralen Antrieb für sämtliche Greifer auf, wobei über ansteuerbare Kupplungen die einzelnen Greifer betätigt werden. In einer zweiten möglichen Ausgestaltung ist jeder Greifer mit einem separaten Antrieb, beispielsweise einem sehr schmal bauenden elektrischen "Voice-Coil-Motor"-versehen. Jeder dieser Antriebe ist auch separat ansteuerbar. Schliesslich ist es auch möglich, jeden Greifer über einzelne Zylinder, die aus Platzgründen auch zueinander versetzt angeordnet sein können, zu betätigen.

In der ersten unteren Endlage befindet sich der Schwenkarm 46 in einer Leerposition der Greifvorrichtung. In dieser Position ist der Greifer mit Abstand zu den in der Lagereinrichtung 42 befindlichen Wafern angeordnet. Auch die Halteelemente 49, 50 und 51 haben Abstand zu den Wafern, so dass der Greifer 44 parallel zur Lagereinrichtung entlang der X-Achse kollisionsfrei verfahrbar ist.

Um einen Wafer aus der Lagereinrichtung zu entnehmen, ist der Greifer mit seinem Schwenkarm 46 zunächst in X-Richtung in einer Ebene anzuordnen, die mit der von einem Wafer gebildeten Ebene fluchtet. Nun kann der Schwenkarm 46 - in bezug auf die Darstellung von Fig. 5 - in Gegenuhrzeigerrichtung in seine Transportposition überführt werden. Bereits unmittelbar nach Beginn dieser Schwenkbewegung kommen die Halteelemente 49, 50 unterhalb einer Durchmesserlinie 54, die parallel zu einer Verbindungslinie 53 der beiden Kontaktstellen der Halteelemente 49, 50 verläuft, in Anlage gegen den Wafer. Der Wafer wird dadurch vom Greifer erfasst und angehoben. Unmittelbar darauffolgend wird das Halteelement 51 passiv betätigt - beispielsweise durch eine Kurvenscheibe oder einen Anschlag - wodurch dieses auf den Wafer zugestellt wird und gegen dessen Seitenkante anliegt. Dadurch ist der Wafer im Greifer fixiert und wird, ohne Relativbewegungen gegenüber dem Greifer auszuführen, von letzterem in die Transportposition mitgenommen. Der Schwenkarm schwenkt bei seiner Bewegung von einer Endlage in die andere um ca. 75°. Auch in der Transportposition ist der Greifer - und selbstverständlich auch der darin befindlichen Wafer - mit Abstand zur Lagereinrichtung und deren Wafern angeordnet. Der Greifer 44 kann somit auch in dieser Endlage kollisionsfrei in X-Richtung entlang der Lagereinrichtung verfahren.

Sobald der Schwenkarm 46 die Transportposition erreicht hat, ist der Greifvorgang abgeschlossen. Die Greifvorrichtung kann nun parallel (in X-Richtung) zum Waferstapel, d.h. in Stapelrichtung der Wafer, verfahren werden, um mit einem anderen Greifer in prinzipiell gleicher Weise den nächsten Wafer aus der Lagereinrichtung 42 zu entnehmen. Dies wird mit jeweils weiteren anderen Greifern solange wiederholt, bis sämtliche zu erfassenden Wafern aus der Lagereinrichtung entnommen und in der Greifvorrichtung angeordnet sind.

Nachdem einer der Greifer mit dem letzten zu greifenden Wafer in seine Verfahrposition geschwenkt worden ist, kann die Greifvorrichtung zur Transferstation verfahren werden, deren Halterechen 37 Aufnahmen für sämtliche Wafer eines Wafer-Batches aufweist. Die in der Greifvorrichtung angeordneten Wafer werden nun an den Halterechen 37 übergeben. Hierzu wird die Greifvorrichtung zunächst neben dem Halterechen angeordnet, so dass jeder Wafer mit einer Aufnahme des Rechens fluchtet. Anschliessend werden sämtliche einen Wafer 48 haltenden Schwenkarme 46 von ihrer Transportposition in ihre Leerposition gleichzeitig geschwenkt. Am Ende der Schwenkbewegung sind die Wafer jeweils in einer Aufnahme angeordnet und befinden sich ausserhalb der Nuten der Halteelemente 49, 50. Bei dieser Bewegung wird auch das Halteelement 51 durch passive Betätigung in seine Freigabeposition zurückgeschwenkt. Dieser Vorgang ist in Fig. 3a gezeigt.

Durch Absenken des Halterechens kann nun das neu zusammengestellte Wafer-Batch an die bis dahin darunter angeordneten Rollen 17, 18 übergeben werden, die nachfolgend das Batch an eine der anderen drei Stationen zur weiteren Handhabung überführt.

Ein Wafer-Batch, das von den Rollen 17, 18 in die Transfer-Station 40 gebracht wird, kann in umgekehrter Reihenfolge von der Transfer-Station in die Lagereinrichtung eingesetzt werden. Hierzu werden als erstes sämtliche Wafer 48 des Batches gleichzeitig von einem der Greifer erfasst und jeweils in die Transportosition geschwenkt. Anschliessend wird jeder Greifer der Greifvorrichtung vor eine Aufnahme der Lagereinrichtung positioniert und der jeweilige Wafer an die Lagereinrichtung übergeben. Hierbei können die Wafer sowohl als gesamtes Batch gleichzeitig oder einzeln nacheinander in die Lagereinrichtung eingesetzt werden. Selbstverständlich ist es auch möglich, eine Anzahl von mehreren Wafern an die Lagereinrichtung 42 gleichzeitig zu übergeben, die kleiner ist als ein Batch. In diesem Fall sind anschliessend die restlichen Wafer - wiederum gleichzeitig oder gruppenweise gemeinsam - in die Lagereinrichtung einzusetzen. Unabhängig davon, in welcher Reihenfolge die Wafer in die Lagereinrichtung eingesetzt werden, wird in einem Speicher einer nicht dargestellten Steuerung der Handhabungsvorrichtung gespeichert, an welcher Position der Lagereinrichtung jeder Wafer eingesetzt ist. Für jeden Wafer können zusätzlich auch Informationen darüber gespeichert werden, welche Prozesse er an welcher Position im Batch bisher durchlaufen hat und welche Prozesse noch zu absolvieren sind.

In Fig. 3 weisen nebeneinanderliegende Aufnahmen der in dieser Darstellung nur mit einer Teillänge gezeigten Lagereinrichtung 42 einen Abstand auf, der kleiner ist, als der übliche Abstand von Wafern in Transportbehältern (sogenannter "Pitch") und als der Abstand, den nebeneinanderliegende Schwenkarme der Greifvorrichtung aufweisen. So kann der Abstand der Aufnahmen beispielsweise die Hälfte oder ein Drittel des üblichen Pitches sein. Sollen sämtliche nebeneinanderliegenden Aufnahmen gefüllt werden, muss somit die Greifvorrichtung jeweils zwischen zwei bereits in der Lagereinrichtung befindliche Wafer ein oder mehrere weitere Wafer einsetzen. Dadurch kann eine Verdichtung des in der Lagereinrichtung angeordneten Wafer-Stapels erzielt werden, wodurch die für eine bestimmte Anzahl an Wafern erforderliche Länge der Lagereinrichtung reduziert werden kann.

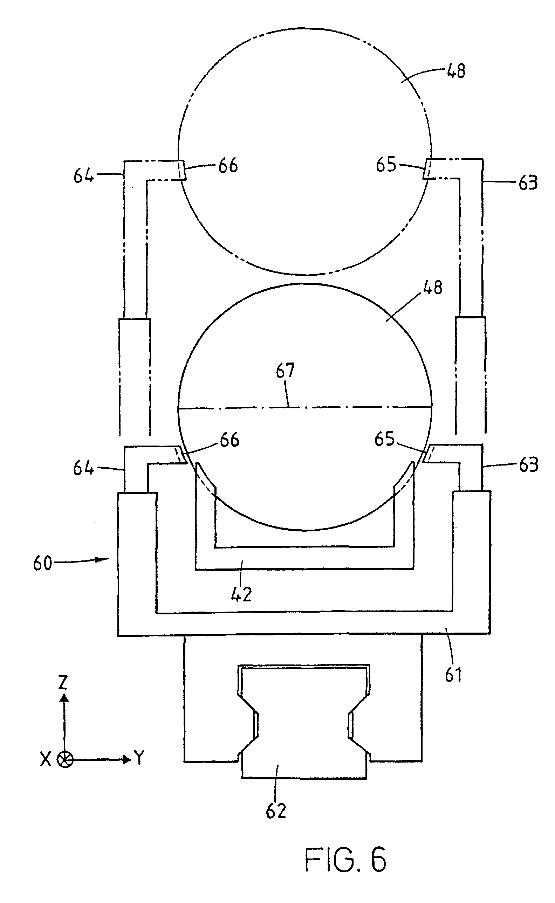

Die erfindungsgemasse Greifvorrichtung kann konstruktiv auch auf andere Weise als in den Fig. 3 bis 5 gezeigt, ausgebildet sein. Wie in Fig. 6 dargestellt ist, kann beispielsweise ein Greifer 60 einer erfindungsgemässen Greifvorrichtung auch in Z-Richtung linear verfahrbar sein, um einen Greifer 60 von seiner Leerposition in seine Transportposition und vice versa zu überführen. Bei dem dargestellten Ausführungsbeispiel ist ein Träger 61 vorgesehen, der an einer unter der Lagereinrichtung 42 angeordneten Führungsschiene 62 linear und in X-Richtung parallel zu dem Wafer-Stapel bzw. der Lagereinrichtung 42 verfahrbar ist. Der Träger 61 umgreift die Lagereinrichtung und weist auf beiden Seiten der Lagereinrichtung 42 einen vertikal verfahrbaren und längs einer Vertikalen verlaufenden Teleskop-Greifarm 63, 64 auf. An einem freien Ende jedes Greifarmes 63, 64 ist jeweils ein zu dem anderen Greifarm weisendes Greifelement 65, 66 vorgesehen, das zur Aufnahme eines Wafers 48 mit einer Nut versehen ist. Die beiden Greifarme 63, 64 eines Greifers führen sämtliche Bewegungen gleichzeitig und synchron aus. Die Greifvorrichtung kann eine Anzahl an derart aufgebauten und voneinander unabhängig betätigbaren Greifern 60 aufweisen, die dem grössten zu handhabenden Wafer-Batch entspricht. Die Betätigung der Greifer kann beispielsweise durch einzelne Pneumatikzylinder, durch einzelne Voice-Coil-Motoren oder durch einen zentralen, an jeden Greifer separat ankuppelbaren, Motor vorgenommen werden. Auch bei diesem Ausführungsbeispiel sind sämtliche Greifer 60 gleichzeitig linear und parallel zur Längserstreckung der Lagereinrichtung (X-Richtung) verfahrbar.

Die Greifer sind in beiden Endlagen gemeinsam in X-Richtung verfahrbar. In einer unteren, in Fig. 6 mit durchgezogenen Linien dargestellten Leerposition, befinden sich die beiden Greifelemente unterhalb einer horizontalen Durchmesserlinie 67 der Wafer 48, so dass die Greifelemente 65, 66 mit Abstand zu den Wafern angeordnet sind. Ist der Greifer mit seinen Greifelementen 65, 66 in X-Richtung auf der Position eines Wafers 48 angeordnet und werden die Greifarme 63, 64 von der unteren in die obere Endlage überführt, so wird hierbei der jeweilige Wafer erfasst und nach oben aus der Lagereinrichtung herausgeführt. In der oberen Verfahrposition ist der jeweilige Wafer 48 in Bezug auf eine Z-Richtung mit Abstand zu den in der Lagereinrichtung 42 befindlichen Wafern angeordnet. Somit ist jeder Greifer in seinen beiden Endlagen in X-Richtung parallel zur Lagereinrichtung verfahrbar.

## Patentansprüche

1. Greifvorrichtung (43) zur Handhabung mehrerer Wafer oder scheibenförmiger Substrate, die mehrere Greifer (44, 60) für jeweils einen Wafer aufweist, wobei die Wafer in den Greifern (44, 60) parallel zueinander angeordnet werden, die Greifer (44, 60) gemeinsam verfahrbar, jedoch unabhängig voneinander betätigbar sind, und durch die Betätigung eines Greifers (44, 60) jeweils zumindest ein Wafer handhabbar ist.

2. Handhabungsvorrichtung für Wafer (Halbleiterscheiben) oder scheibenförmige Substrate, welche eine Lagereinrichtung aufweist, in der mehrere Wafer mit ihren Oberflächen im wesentlichen parallel zueinander ausgerichtet, hintereinander und ausserhalb eines Transportbehälter anordenbar sind,
**dadurch gekennzeichnet, dass** die Handhabungsvorrichtung mit einer Greifvorrichtung nach Anspruch 1 versehen ist.

3. Handhabungsvorrichtung nach Anspruch 2, **dadurch gekennzeichnet, dass** die Anzahl der Greifer der Greifvorrichtung, der Anzahl an Wafern eines Waferbatches oder einem ganzzahligen Vielfachen davon entspricht.

4. Handhabungsvorrichtung nach Anspruch 2 oder 3, **dadurch gekennzeichnet, dass** Greifer der Greifvorrichtung an einem gemeinsamen Schlitten angeordnet sind, welcher an einem Führungselement parallel zur Lagereinrichtung verfahrbar ist.

5. Handhabungsvorrichtung nach einem oder mehreren der vorhergehenden Ansprüche 2 bis 4, **dadurch gekennzeichnet, dass** Greifer in zwei Endlagen schwenkbar sind, wobei sie sich in einer ersten Endlage in einer Leerposition und in einer zweiten Endlage in einer Transportposition für Wafer der Greifvorrichtung befinden, in welcher sie Wafer im wesentlichen parallel zur Lagereinrichtung transportieren.

6. Handhabungsvorrichtung nach Anspruch 5, **dadurch gekennzeichnet, dass** die Schwenkbewegung des Greifers in einer Ebene stattfindet, welche im wesentlichen orthogonal zur Verfahrrichtung der Greifvorrichtung und parallel zu den Oberflächen der Wafer der Lagereinrichtung ausgerichtet ist.

7. Handhabungsvorrichtung nach einem oder mehreren der vorhergehenden Ansprüche 2 bis 6, **dadurch gekennzeichnet, dass** Greifer der Greifvorrichtung, unabhängig von anderen Greifern der Greifvorrichtung, im wesentlichen parallel zu den Oberflächen der Wafer und quer zur Verfahrrichtung der Greifvorrichtung geradlinig bewegbar sind, wobei sie sich in einer ersten Endlage in einer Leerposition und in einer zweiten Endlage in einer Transportposition für Wafer der Greifvorrichtung befinden, in welcher sie Wafer im wesentlichen parallel zur Lagereinrichtung transportieren.

8. Handhabungsvorrichtung nach einem oder mehreren der vorhergehenden Ansprüche 2 bis 7, **dadurch gekennzeichnet dass** in die Lagereinrichtung eine Anzahl an Wafern einsetzbar ist, die zumindest im wesentlichen einem ganzzahligen Vielfachen der Anzahl an Wafern entspricht, die durch die Greifvorrichtung gleichzeitig handhabbar sind.

9. Handhabungsvorrichtung nach einem oder mehreren der vorhergehenden Ansprüche 2 bis 8, **gekennzeichnet durch** eine im Verfahrweg der Greifvorrichtung angeordnete Transfer-Station mit einem Zwischenlager für Wafer, in dem mehrere Wafer mit ihren Oberflächen parallel zueinander angeordnet werden können, wobei mit der Greifvorrichtung Wafer von der Lagereinrichtung zur Transferstation und umgekehrt überführbar sind.

10. Speichervorrichtung für eine Zwischenlagerung von Wafern oder scheibenförmiger Substrate, die ein Gehäuse aufweist, das einen Innenraum ausbildet, in dem mehrere Speicherplätze für Transportbehälter von Wafern vorhanden sind, die Speichervorrichtung mit einem Manipulator versehen ist, der die Transportbehälter handhabt, wobei zumindest ein Teil des Innenraumes als Reinraumbereich ausgebildet ist, in dem Wafer ausserhalb von Transportbehältern handhabbar und in einer Lagereinrichtung zwischenlagerbar sind, wobei zumindest eine Greifvorrichtung nach Anspruch 1 vorhanden ist.

11. Speichervorrichtung nach Anspruch 10, **gekennzeichnet durch** eine Handhabungsvorrichtung nach einem oder mehreren der vorhergehenden Ansprüche 3 bis 9.

12. Verfahren zur Zusammenstellung eines Waferbatches, bei welchem zunächst Wafer in einer Lagereinrichtung als Ausgangs-Waferstapel angeordnet werden, nachfolgend mit einer Greifvorrichtung nach Anspruch 1 einzelne Wafer aus dem Ausgangs-Waferstapel entnommen und in einer vorbestimmten Reihenfolge wieder angeordnet werden, wobei zunächst mit einer Greifvorrichtung (43) nach Anspruch 1 nacheinander mehrere Wafer (48) aus der Lagereinrichtung entnommen und erst danach die entnommenen Wafer von der Greifvorrichtung (43) an die Lagereinrichtung oder an eine hiervon unterschiedliche Halteeinrichtung übergeben werden.

13. Verfahren zur Zusammenstellung eines Waferbatches, bei welchem zunächst Wafer in einer Lagereinrichtung als Ausgangs-Waferstapel angeordnet werden, nachfolgend mit einer Greifvorrichtung nach Anspruch 1 einzelne Wafer aus dem Ausgangs-Waferstapel entnommen und in einer vorbestimmten Reihenfolge wieder angeordnet werden, wobei die Greifvorrichtung (43) in einer bestimmten Position gegenüber der Lagereinrichtung angeordnet wird, die Greifvorrichtung in dieser Position aus dem Ausgangs-Waferstapel mehrere Wafer entnimmt, die Greifvorrichtung (43) in zumindest eine andere Position verfahren wird und diese Wafer nacheinander an die Lagereinrichtung oder an eine hiervon abweichende Halteeinrichtung übergibt.

14. Verfahren nach Anspruch 12 oder 13, **dadurch gekennzeichnet, dass** die Greifvorrichtung (43) Wafer eines in einer Übergabestation angeordneten Waferbatches erfasst, die Wafer an Lagerstellen der Lagereinrichtung absetzt und die Positionen von jedem der Wafer in der Lagereinrichtung zusammen mit Daten zur Identifizierung des Batches, in dem sich der Wafer zuvor befand und/oder Daten bezüglich von dem jeweiligen Wafer bereits durchlaufenen Bearbeitungsprozessen speichert.

15. Verfahren nach einem oder mehreren der vorhergehenden Ansprüche 12 bis 14, **dadurch gekennzeichnet, dass** die Greifvorrichtung (43) zwischen der Entnahme eines ersten und der Entnahme eines letzten Wafers im wesentlichen parallel zu einer Stapelrichtung der Wafer verfährt.

## Claims

1. Gripping device (43) for handling a plurality of wafers or disc-like substrates, which device has a plurality of grippers (44, 60) for one wafer in each case, wherein the wafers are arranged parallel to each other in the grippers (44, 60), the grippers (44, 60) can be moved jointly to but actuated independently of each other and, by actuating a gripper (44, 60), it is possible for at least one wafer to be handled in each case.

2. Handling device for wafers (semiconductor discs) or disc-like substrates, comprising a storage facility in which a plurality of wafers aligned with their surfaces substantially parallel to each other can be arranged one after another and outside a transport container, **characterized in that** the handling device is provided with a gripping device according to Claim 1.

3. Handling device according to Claim 2, **characterized in that** the number of grippers of the gripping device corresponds to the number of wafers in a wafer batch or an integer multiple thereof.

4. Handling device according to Claim 2 or 3, **characterized in that** grippers of the gripping device are arranged on a common slide, which can be moved on a guide element parallel to the storage facility.

5. Handling device according to one or more of the preceding Claims 2 to 4, **characterized in that** grippers can be pivoted into two end positions, being in an empty position in a first end position and in a transport position for wafers of the gripping device in a second end position, in which the said grippers transport wafers substantially parallel to the storage facility.

6. Handling device according to Claim 5, **characterized in that** the pivoting movement of the gripper takes place in a plane which is aligned substantially orthogonally with respect to the direction of travel of the gripping device and parallel to the surfaces of the wafers of the storage facility.

7. Handling device according to one or more of the preceding Claims 2 to 6, **characterized in that** grippers of the gripping device can be moved rectilinearly, independently of other grippers of the gripping device, substantially parallel to the surfaces of the wafers and transversely with respect to the direction of travel of the gripping device, wherein they are in an empty position in a first end position and in a transport position for wafers of the gripping device in a second end position, in which the said grippers transport wafers substantially parallel to the storage facility.

8. Handling device according to one or more of the preceding Claims 2 to 7, characterized is that a number of wafers can be inserted into the storage facility, the number corresponding substantially to an integer multiple of the number of wafers which can be handled simultaneously by the gripping device.

9. Handling device according to one or more of the preceding Claims 2 to 8, **characterized by** a transfer station arranged on the travel path of the gripping device and having an intermediate store for wafers, in which a plurality of wafers can be arranged with their surfaces parallel to one another, wherein it is possible to use the gripping device to transfer wafers from the storage facility to the transfer station and vice versa.

10. Storage device for the intermediate storage of wafers or disc-like substrates, which device has a housing which forms an internal space in which there are a plurality of storage spaces for transport containers for wafers, the storage device is provided with a manipulator which handles the transport containers, at least part of the internal space being designed as a clean room area, in which wafers can be handled outside transport containers and can be stored intermediately in a storage facility, wherein at least one gripping device is present according to Claim 1.

11. Storage device according to Claim 10, **characterized by** a handling device according to one or more of the preceding Claims 3 to 9.

12. Method of assembling a wafer batch, in which, firstly, wafers are arranged in a storage facility as an output wafer stack, individual wafers are then removed from the outlet wafer stack by a gripping device according to Claim 1 and arranged in a predetermined order again, wherein, first of all, a gripping device (43) according to Claim 1 is used to remove a plurality of wafers (48) one after another from the storage facility and only then the removed wafers are transferred by the gripping device (43) to the storage facility or to a holding device different from the latter.

13. Method of assembling a wafer batch, in which, firstly, wafers are arranged in a storage facility as an output wafer stack, individual wafers are then removed from the output wafer stack by a gripping device according to Claim 1 and arranged in a predetermined order again, wherein the gripping device (43) is arranged in a specific position with respect to the storage facility, the gripping device removes a plurality of wafers from the output wafer stack in this position, the gripping device (43) is moved into at least one other position and transfers these wafers one after another to the storage facility or to a holding device differing from the latter.

14. Method according to Claim 12 or 13, **characterized in that** the gripping device (43) grips wafers of a wafer batch arranged in a transfer station, sets the wafers down at storage locations in the storage facility and stores the positions of each of the wafers in the storage facility, together with data for identifying the batch in which the wafer was previously located and/or data with respect to the processing processes which the respective wafer has already passed through.

15. Method according to one or more of the preceding Claims 12 to 14, **characterized in that** between the removal of a first and the removal of a last wafer, the gripping device (43) moves substantially parallel to a stacking direction of the wafers.

## Revendications

1. Dispositif de préhension (43) pour la manipulation de plusieurs pastilles ou de plusieurs substrats en forme de disque, qui présente plusieurs pinces de préhension (44, 60) pour respectivement une pastille, dans lequel les pastilles dans les pinces de préhension (44, 60) sont disposées en position réciproquement parallèle, les pinces de préhension (44, 60) étant à même de se déplacer de manière conjointe, tout en pouvant être actionnées indépendamment l'une de l'autre, et respectivement qu'au moins une pastille peut être manipulée par l'actionnement d'une pince de préhension (44, 60).

2. Dispositif de manipulation pour des pastilles (des plaquettes de semi-conducteurs) ou pour des substrats en forme de disque, qui présente un mécanisme d'entreposage dans lequel plusieurs pastilles peuvent venir se disposer à l'extérieur d'un récipient de transport, l'une derrière l'autre et de telle sorte que leurs surfaces soient orientées essentiellement parallèlement l'une à l'autre, **caractérisé en ce que** le dispositif de manipulation est muni d'un dispositif de préhension selon la revendication 1.

3. Dispositif de manipulation selon la revendication 2, **caractérisé en ce que** le nombre des pinces de préhension du dispositif de préhension correspond au nombre de pastilles d'un lot de pastilles ou à un multiple entier du nombre en question.

4. Dispositif de manipulation selon la revendication 2 ou 3, **caractérisé en ce que** des pinces de préhension du dispositif de préhension sont disposées sur un chariot commun, qui est à même de se déplacer sur un élément de guidage parallèlement au mécanisme d'entreposage.

5. Dispositif de manipulation selon une ou plusieurs des revendications précédentes 2 à 4, **caractérisé en ce que** des pinces de préhension sont à même de pivoter dans deux positions terminales, dans lequel lesdites pinces se trouvent, dans une première position terminale, dans une position de repos et, dans une deuxième position terminale, dans une position de transport pour des pastilles du dispositif de préhension, dans laquelle elles transportent des pastilles essentiellement en position parallèle par rapport au mécanisme d'entreposage.

6. Dispositif de manipulation selon la revendication 5, **caractérisé en ce que** le mouvement de pivotement de la pince de préhension a lieu dans un plan qui est orienté essentiellement perpendiculairement par rapport à la direction de déplacement du dispositif de préhension et parallèlement aux surfaces des pastilles du mécanisme d'entreposage.

7. Dispositif de manipulation selon une ou plusieurs des revendications précédentes 2 à 6, **caractérisé en ce que** des pinces de préhension du dispositif de préhension, indépendamment d'autres pinces de préhension du dispositif de préhension, sont mobiles en ligne droite essentiellement parallèlement aux surfaces des pastilles et transversalement par rapport à la direction de déplacement du dispositif de préhension, dans lequel lesdites pinces se trouvent, dans une première position terminale, dans une position de repos et, dans une deuxième position terminale, dans une position de transport pour des pastilles du dispositif de préhension, dans laquelle elles transportent des pastilles essentiellement en position parallèle par rapport au mécanisme d'entreposage.

8. Dispositif de manipulation selon une ou plusieurs des revendications précédentes 2 à 7, **caractérisé en ce qu'**un certain nombre de pastilles peuvent venir s'insérer dans le mécanisme d'entreposage, ledit nombre correspondant au moins essentiellement à un multiple entier du nombre de pastilles qui peuvent être manipulées de manière simultanée par le dispositif de préhension.

9. Dispositif de manipulation selon une ou plusieurs des revendications précédentes 2 à 8, **caractérisé par** un poste de transfert disposé dans la voie de déplacement du dispositif de préhension, comprenant un entreposage intermédiaire pour des pastilles dans lequel plusieurs pastilles peuvent venir se disposer de telle sorte que leurs surfaces soient orientées parallèlement l'une à l'autre, dans lequel, avec le dispositif de préhension, des pastilles peuvent être transférées depuis le mécanisme d'entreposage jusqu'au poste de transfert et inversement.

10. Dispositif de stockage pour un entreposage intermédiaire de pastilles ou de substrats en forme de disque, qui présente un logement qui forme un espace interne dans lequel sont présents plusieurs endroits de stockage pour des récipients de transport de pastilles, le dispositif de stockage étant muni d'un manipulateur qui manipule le récipient de transport, dans lequel au moins une partie de l'espace interne est réalisée sous la forme d'une chambre blanche dans laquelle des pastilles peuvent être manipulées à l'extérieur de récipient de transport et peuvent être soumises à un entreposage intermédiaire dans un mécanisme d'entreposage, dans lequel au moins un dispositif de préhension selon la revendication 1 est présent.

11. Dispositif de stockage selon la revendication 10, **caractérisé par** un dispositif de manipulation selon une ou plusieurs des revendications précédentes 3 à 9.

12. Procédé pour le regroupement d'un lot de pastilles, dans lequel on dispose d'abord des pastilles dans un mécanisme d'entreposage sous la forme d'une pile de pastilles de départ ; on prélève ensuite, avec un dispositif de préhension selon la revendication 1, des pastilles individuelles de la pile de pastilles de départ et on les dispose à nouveau dans un ordre prédéterminé, dans lequel on prélève d'abord, avec un dispositif de préhension (43) selon la revendication 1, successivement plusieurs pastilles (48) du mécanisme d'entreposage et, seulement après, on transfère les pastilles prélevées du dispositif de préhension (43) au mécanisme d'entreposage ou à un mécanisme de maintien différent du dernier cité.

13. Procédé pour le regroupement d'un lot de pastilles, dans lequel on dispose d'abord des pastilles dans un mécanisme d'entreposage sous la forme d'une pile de pastilles de départ ; on prélève ensuite, avec un dispositif de préhension selon la revendication 1, des pastilles individuelles de la pile de pastilles de départ et on les dispose à nouveau dans un ordre prédéterminé, dans lequel le dispositif de préhension (43) est disposé dans une position déterminée par rapport au mécanisme d'entreposage, le dispositif de préhension prélève, dans cette position, plusieurs pastilles de la pile de pastilles de départ, le dispositif de préhension (43) se déplace pour prendre au moins une autre position et transfère ces pastilles de manière successive au mécanisme d'entreposage ou à un mécanisme de maintien qui s'écarte de ce dernier.

14. Procédé selon la revendication 12 ou 13, **caractérisé en ce que** le dispositif de préhension (43) saisit un lot de pastilles disposé dans un poste de transfert, dépose les pastilles à des endroits d'entreposage du mécanisme destiné à cet effet et mémorise les positions de chacune des pastilles dans le mécanisme d'entreposage de manière conjointe avec des données pour l'identification du lot dans lequel se trouvait la pastille au préalable et/ou des données concernant la pastille respective de processus de traitement déjà mis en oeuvre.

15. Procédé selon une ou plusieurs des revendications précédentes 12 à 14, **caractérisé en ce que** le dispositif de préhension (43) se déplace, entre le prélèvement d'une première pastille et le prélèvement d'une dernière pastille, essentiellement parallèlement à une direction d'empilement des pastilles.
